# EUROPEAN PATENT APPLICATION

(11) **EP 4 394 897 A1**
(43) Date of publication of application: **03.07.2024**
(21) Application number: 22217403.9
(22) Date of filing: 30.12.2022
(51) Int. Cl.: H01L 31/048, B29C 45/14, B29C 45/56, B29C 33/14, B29C 33/18

(54) **METHOD AND DEVICE FOR PRODUCING A PV PANEL WITH A MOULDED SUPPORT STRUCTURE USING PRE-FIXATION IN A MOULDING DEVICE**

(71) Applicant: Sono Motors GmbH, 80935 München (DE)
(72) Inventor: THENER, Sebastian, 80935 Munich (DE); KÖHNLEIN, Dominik, 80935 Munich (DE); RIBEIRO, Eduardo, 80935 Munich (DE); RAMESHA, Harshan, 80935 Munich (DE)
(74) Representative: Qip Patentanwälte Dr. Kuehn & Partner mbB

(57) **Abstract**

A method and a moulding device (27) for producing a photovoltaic panel (1), particularly a photovoltaic vehicle body panel, are described. The method comprises:
providing a sheet-like PV label (3) comprising front side and rear side polymeric foils (9, 11, 13, 15) as well as an interposed solar cell arrangement (17), and
preparing a support structure (5) for supporting the photovoltaic label using a moulding device (27) having a core side moulding half (23) and a cavity side moulding half (25) being displaceable relative to each other between an open state and a closed state and enclosing a cavity (33) with an inner surface (35) having a predetermined shape, and further comprising a pre-fixing arrangement (39), a pushing arrangement (41) and an injection arrangement (52).

The support structure is prepared by
- arranging the PV label between the two moulding halves (23, 25) in the open state,
- pre-fixing the PV label adjacent to the concave inner surface (35) using the pre-fixing arrangement (39),
- pushing and thereby bending the PV label using a displaceable plunger (43) of the pushing arrangement such that the PV label abuts with a front surface (19) to a recessed portion (45) of the concave inner surface (35),
- closing the moulding device and injecting a viscous polymer mass (29) to a rear surface (21) of the PV label (3) using the injection arrangement, and
- after solidification of the injected polymer mass, opening the moulding device and removing the PV label with the support structure attached thereto from the moulding device.

## Description

### FIELD OF THE INVENTION

The present invention relates to a method for producing a photovoltaic panel, particularly for producing a photovoltaic vehicle body panel or other vehicle-related photovoltaic panel, into which a solar cell arrangement is integrated. Furthermore, the present invention relates to a moulding device being configured for implementing such a method.

### TECHNICAL BACKGROUND

The method and device described herein may be applied for producing a photovoltaic panel which may be used and/or be specifically configured for various application fields such as for installation at vehicles, on building roofs or at other structures. However, details of the approach suggested will be described herein with a focus on photovoltaic vehicle body panels. While the term "vehicle body panel" may refer to a panel which may be included in a body of any kind of vehicles such as cars, trucks, busses, mobile homes, trains, ships, airplanes, etc., embodiments are described herein with reference to car body panels for simplicity of description.

In the following, the term "photovoltaic" may be abbreviated by "PV". PV cells may also be referred to as solar cells. A body panel of a vehicle including an integrated PV module may be referred to herein as PV integrated car body panel.

Conventionally, most commercially available PV panels are typically produced by providing planar, rigid, wafer-based solar cells and then laminating these solar cells between a front side glass sheet and a rear side support structure such as another glass sheet or a metal sheet. Therein, the solar cells are interposed between thin lamination foils serving for both, tightly encapsulating the solar cells and mechanically interconnecting the stack including the front and rear side sheets with the interposed solar cell arrangement. Such PV panels are also referred to as PV modules and have typically a planar structure. These PV panels are well suited for installation on buildings or in solar farms. However, such planar PV panels are hardly suited for an integration into curved surfaces such as for example surfaces of body panels of a car or another vehicle.

Approaches have been presented in which PV cells are provided at a body of a car for generating electricity to be supplied to the car. Such electricity may be used for example for charging batteries of an electric car.

For example, it has been proposed e.g. in an earlier patent application WO 2019/020718 A1 of the present applicant to provide solar cells in a body panel of a vehicle. Therein, a PV module shall be placed on top of such a body panel or, preferably, the PV module shall be integrated into the body panel. Specifically, one or more solar cells may be arranged in an air tight and water tight manner in a recess provided in a carrier structure of a car body panel.

In an alternative approach for manufacturing PV modules, it has been proposed by the present applicant in an earlier patent application WO 2020/187792 A1 to integrate a solar cell arrangement into a moulded layer formed by injection moulding. Therein, the solar cell arrangement is interposed between polymeric foils, thereby forming a so-called photovoltaic label which may be securely handled and in which the solar cells shall be for example protected against excessive mechanical stress during an injection moulding procedure.

Further approaches for a car body panel comprising an integrated solar cell arrangement have been proposed by the present applicant in earlier patent applications WO 2022/122507 A1 and DE 10 2022 101 935 A1.

In each of these prior art approaches, the panel or, specifically, the car body panel including the solar cell arrangement may be regarded as a PV module having a non-planar shape.

Possible features and characteristics of such approaches of car body panels and approaches for fabricating a car body panel including a photovoltaic module have been described by the applicant in the above mentioned patent applications as well as in further prior patent applications such as WO 2021/260021 A1 (title: "Method for fabricating a photovoltaic module including laser cutting of a photovoltaic label"), WO 2021/260024 A1 (title: "Method for fabricating a curved photovoltaic module including adapted positioning of photovoltaic cells") and DE 10 2022 108 014 A1 (title "Method for fabricating a Photovoltaic Module using In-Mould Labelling with specific Temperature Management").

Furthermore, the applicant of the present application filed another patent application in parallel, i.e. simultaneously, with the present one. This other patent application addresses details of a specific technique for producing a PV panel generally using a so-called injection compression moulding technique, such details also possibly being applicable in the approach presented in the present application.

Features and characteristics of the approaches described in the mentioned prior and/or parallel applications may also apply to the production method and the moulding device described herein and the content of these patent applications shall be incorporated in its entirety herein by reference.

### SUMMARY OF THE INVENTION AND OF EMBODIMENTS

It may be an object to provide an alternative method for producing a PV panel, particularly a PV vehicle body panel, in which a solar cell arrangement is integrated and which fulfils both, very high functional requirements as well as very high aesthetic requirements. Furthermore, it may be an object to provide a production method which enables a relatively simple fabrication procedure, high fabrication yield and/or low fabrication costs while providing a fabrication result as a highly functional, reliable and aesthetic PV-integrated (car body) panel. Furthermore, it may be an object to provide a moulding device being specifically configured for implementing the proposed method and enabling PV panel production in a reliable and cost efficient manner.

Such objects may be met with the subject-matter of the independent claims. Advantageous embodiments are defined in the dependent claims and described in the following specification and visualised in the associated figures.

According to a first aspect of the present invention, a method for producing a photovoltaic panel is described. The photovoltaic panel may be a vehicle body part or may be a photovoltaic panel for a building or the like. The inventive method comprises at least the following steps, preferably in the indicated order:
(i) providing a photovoltaic label comprising front side and rear side polymeric foils as well as a solar cell arrangement interposed between the front and rear side polymeric foils, and
(ii) preparing a support structure for supporting the photovoltaic label using a moulding device having two moulding halves including a core side moulding half and a cavity side moulding half being displaceable relative to each other between an open state and a closed state. Therein, the core side moulding half and the cavity side moulding half are configured such as to, in the closed state of the moulding device, enclose a cavity. The core side moulding half comprises a concave inner surface. The moulding device further comprises a pre-fixing arrangement, a pushing arrangement and an injection arrangement.

Therein, the support structure is prepared including the following steps, preferably, but not necessarily in the indicated order:
(a) arranging the photovoltaic label between the two moulding halves upon the moulding device being in the open state,
(b) pre-fixing the photovoltaic label adjacent to the concave inner surface of the core side moulding half using the pre-fixing arrangement,
(d) closing the moulding device to a closed state by pushing the core side moulding half towards the cavity side moulding half and injecting a viscous polymer mass to a rear surface of the photovoltaic label using the injection arrangement, and
(e) after solidification of the injected polymer mass thereby forming the support structure, opening the moulding device and removing the photovoltaic label with the support structure attached thereto from the moulding device.

During the closing procedure, the core side or moving moulding half is pushed towards the cavity side or fixed moulding half until a predetermined closing state is reached.

It is noted that the core side moulding half may also be regarded or referred to as the moving moulding half of the moulding device, and the cavity side moulding half may be regarded or referred to as the fixed moulding half of the moulding device. Therefore, for opening or closing the moulding device, the core side moulding half is either moved towards the cavity side moulding half or away from it, in particular, during the closing procedure, the core side moulding half is moved towards the cavity side moulding half up to a predetermined point or closing state, whereas during the opening procedure of the moulding device, the core side moulding half is moved away from the cavity side moulding half.

Also, it is conceivable that the whole procedure takes place vice versa, if the core side moulding half is the fixed moulding half and the cavity side moulding half is the moving moulding half. Then, for the opening procedure, the cavity side moulding half will be moved away from the core side moulding half and for the closing procedure, the cavity side mould half will be moved towards the core side mould half.

According to a second aspect of the invention, a moulding device is described. The moulding device comprises:
- a core side moulding half and a cavity side moulding half being, wherein the core side moulding half is movable relative to the cavity side moulding half so as to open and close the moulding device, wherein the core side moulding half and the cavity side moulding half are configured such as to, in the closed state of the moulding device, enclose a cavity and wherein the core side moulding half comprises an planar or 3D-shaped inner surface,
- a pre-fixing arrangement arranged at the core side moulding half and configured for pre-fixing a sheet-like photovoltaic label adjacent to the inner surface of the core side moulding half,
- a pushing arrangement configured for displacing a plunger towards the inner surface of the core side moulding half,
- an injection arrangement configured for injecting a viscous polymer mass towards the cavity.

The 3D-shaped inner surface may have any desired shape, but preferably may be concave.

Preferably, the moulding device is configured for implementing the method according to an embodiment of the first aspect of the invention.

Briefly summarised and without limiting the scope of the invention, basic ideas underlying embodiments of the invention and associated possible advantages will be roughly described as follows:
As indicated above, various approaches for producing PV panels with a potentially curved surface have been suggested. At least some of these approaches rely on a use of injection moulding techniques or, more specifically, on a use of in-mould labelling techniques. In such techniques, a viscous polymer mass including e.g. molten thermoplastic polymer material is injected into a cavity in an injection moulding device, wherein a PV label has been arranged within this cavity prior to the polymer injection.

However, while such approaches of preparing a PV panel by moulding the solar cell arrangement into a support structure prepared by conventional injection moulding appears to allow rapid production of large numbers of PV panels, it has been observed that handling the photovoltaic label with its solar cell arrangement during the injection moulding procedure may be challenging. Particularly, it has been observed that there is a risk that solar cells of the solar cell arrangement break during the injection moulding procedure unless suitable provisions are made for preventing such solar cell breakage.

Actually, it has been observed that such solar cell breakage may result from the fact that, in conventional injection moulding, a thermoplastic polymer is typically injected into a cavity comprised in a mould, such injection being applied with very high pressures.

While such high pressurised injection may enable fast manufacturing, it is assumed that the injected thermoplastic polymer may exert an excessive pressure and/or local pressure peaks onto the solar cells in the PV label, thereby inducing a risk of solar cell breakage.

In order to, inter alia, reduce such risk of solar cell breakage, it is suggested herein to specifically fix the PV label to the core side moulding half of the moulding device before starting an actual polymeric injection procedure. Particularly, the PV label may be fixed by suspending it within the core side moulding half. Therefore, through-holes are pre-drilled in the PV label, for example, at its edges which for suspending the PV label in the core side moulding half, are brought into engagement with respective pins that are provided at the inner surface of the core side moulding half. Alternatively or additionally, the PV label may be fixed in a two-step approach. Therein, the PV label is first pre-fixed at the core side moulding half adjacent to its concave inner surface. For such purpose, the moulding device comprises a pre-fixing arrangement. For example, such prefixing arrangement may comprise a vacuum or suction arrangement with a suction cup for generating an underpressure in a suction area. Due to such underpressure, the PV label may be sucked towards the concave inner surface and may thereby at least preliminarily be fixed adjacent to this concave inner surface. However, it has been found that, as the PV label typically has a relatively high stiffness, i.e. a low bendability, it may be difficult to reliably draw the PV label into direct contact with the concave inner surface of the core side moulding half using such pre-fixation only. Accordingly, additionally to such pre-fixation, the PV label is then mechanically pushed towards the inner surface of the core side moulding half using a displaceable plunger of a pushing arrangement included in the moulding device. Such pushing arrangement may be comprised e.g. at the cavity side moulding half and its plunger may be displaced towards the concave inner surface of the core side moulding half, thereby pushing and bending the PV label disposed between both moulding halves into a configuration in which the front surface of the PV label abuts to a recessed portion of the concave inner surface. Accordingly, due to such pushing action, the PV label is reliably pressed into and held at the recessed portion of the concave inner surface before starting the actual polymer injection procedure. Thus, the PV label and, particularly, its solar cell arrangement may be supported along a wide area by the inner surface of the core side moulding half upon being subjected to the high-pressure polymer injection. The risk of solar cell breakage may be reduced accordingly.

In the following, possible features of embodiments of the invention and associated possible advantages will be described in more detail.

The approach proposed herein is particularly suitable for a PV-integrated (car body) panel comprising a solar cell arrangement with multiple PV cells which are prepared based on brittle semiconductor wafers such as crystalline silicon wafers. Such PV cells are relatively rigid, i.e. they may generally not be bent into small bending radii of e.g. less than their lateral dimensions. The solar cell arrangement is generally comprised in an encapsulation including a front side polymeric foil and a rear side polymeric foil into which the solar cells, electrical interconnections and possibly other components are embedded. Furthermore, the solar cell arrangement may be reinforced by one or more stabilisation foils for forming a PV label. The entire PV label may then have a thickness in a range of between 0.5 mm to 10 mm, typically between 0.5 mm to 5 mm or between 1 mm and 3 mm. Lateral dimensions of the PV label may range from about 0.1 m to 4 m, typically from 0.2 m to 2 m. The PV label may be flexible and bendable and may be formed into a curved contour being adapted e.g. to a shape of the intended car body panel. Therein, the solar cells comprised in the car body panel cover a substantial portion, i.e. for example more than 30%, preferably more than 50% or even more than 70%, of an outer surface of the car body panel.

It shall be noted that, while specific details of the PV label and its components are generally not essential for the understanding of the inventive method and device described herein, such details are described in an exemplary manner in the prior patent applications mentioned in the introductory portion and, particularly, in the patent application filed by the applicant contemporarily with the present application.

The PV label is generally stiff and hardly bendable since it comprises a reinforcement or support structure in order to provide a self-supporting PV pane. Such support structure typically has a higher mechanical stability than the PV label. Such higher mechanical stability may result, interalia, from larger geometrical dimensions such as a larger thickness compared to the thickness of the PV label and/or higher stiffness due to material properties of the polymer used. The support structure and the PV label are generally mechanically interconnected such that forces acting onto the PV label may be transmitted to the support structure and vice versa.

According to the approach described herein, the support structure shall be manufactured using a processable polymer via injection moulding, preferably an injection compression moulding technique.

Such technique may be implemented with a moulding device in accordance to an embodiment of the second aspect of the invention.

Such moulding device generally comprises two moulding halves which may be displaced relative to each other between an open state and a closed state. One moulding half is referred to as core side or moving moulding half, the other one as cavity or fixed side moulding half. The configuration, as described above, may also be implemented vice versa. In the open state, the two moulding halves are arranged with a distance from each other, i.e. there is a gap between the moulding halves. The distance may be at least some centimetres or even several decimetres. Particularly, the distance should be large enough to initially insert the PV label between the two moulding halves and, upon completion of the compression moulding procedure, remove the final PV panel from between the two moulding halves. Starting from this open, spaced state, the moulding halves may be displaced towards each other in order to come to the closed state. For such purpose, the moulding device may have an actuator arrangement including e.g. one or more electromotors, hydraulics, pneumatics, etc. with which one or both of the moulding halves may be displaced. In the closed state, the two moulding halves are in tight contact with each other at least along a rim of the moulding halves. Both moulding halves have surfaces directed to each other, these surfaces being enclosed by the rim and being therefore referred to herein as inner surfaces. These inner surfaces have a contour such that a cavity is enclosed between the opposing surfaces upon the moulding halves being in the closed state. At least one of such inner surfaces has a generally concave contour, i.e. the inner surface comprises at least one recessed portion being recessed relative to the circumferentially enclosing rim. The other one of the inner surfaces may have a generally 3D-shaped, for example, concave or convex or a planar contour. Therein, the inner surfaces are contoured such that the enclosed cavity generally has the intended form of the PV panel to be produced. Particularly, the inner surfaces as well as the surfaces of the resulting PV panel may have a curved contour with curvatures being present in one or two directions.

Furthermore, the moulding device comprises a fixation arrangement. This fixation arrangement is specifically configured for fixing the sheet-like photovoltaic label to the core side moulding half in a way such that the PV label abuts at least with a partial area of its front surface to at least a partial area of the inner surface of the core side moulding half. In such fixed state, the rear side of the PV label is directed to the inner surface of the cavity side moulding half. However, at least partial areas of the rear side surface of the PV label are spaced apart from the inner surface of the cavity side moulding half via interposed portions of the cavity. Generally, the fixation arrangement shall be configured for fixing the PV label such that the PV label may withstand forces applied to it during the injection moulding procedure. Furthermore, the PV label shall be fixed in a reversible manner in order to enable simple removal of the final product, i.e. the final PV panel, from the moulding device after completion of the moulding procedure. Additionally, the fixation arrangement shall be configured such as to enable fixing the PV label without damaging the fragile solar cells enclosed therein.

For such purpose, the fixation arrangement comprises a pre-fixing arrangement as well as a pushing arrangement.

The pre-fixing arrangement is arranged at the core side moulding half. Alternatively, the prefixing arrangement may be arranged at the cavity side moulding half and in this case, the PV label will be pre-fixed within the latter.

Particularly, the pre-fixing arrangement is arranged at or close to the inner surface of the core side moulding half. Accordingly, the pre-fixing arrangement may be used for fixing the sheet-like PV label adjacent to this concave inner surface at least in a preliminary phase at the beginning of the procedure for preparing the support structure, i.e. in a situation in which the moulding device is in its open state. In such phase, the photovoltaic label may have a planar or only slightly curved shape. Particularly, while being held by the pre-fixing arrangement in such initial phase, the photovoltaic label might not be in full contact with the inner surface of the core side moulding half. Possible details of embodiments of the pre-fixing arrangement will be described further below.

The pushing arrangement may then be used for pushing the pre-fixed PV label further towards the concave inner surface of the core side moulding half. The pushing arrangement is preferably situated at or within the cavity side moulding half. Therein, a plunger of the pushing arrangement may be displaced between a retracted position and a projecting position. In the retracted position, the plunger is situated distant to the core side moulding half and, particularly, may not yet be in mechanical contact with the PV label arranged at the core side moulding half. In the projecting position, at least a tip portion of the plunger forming a pressing surface is displaced towards the core side moulding half to such an extend such as to project into the recessed portion of the concave inner surface of the core side moulding half. Accordingly, in such projecting position, the plunger pushes the PV label arranged at the core side moulding half into such recessed portion and, preferably, until the PV label is pressed against the concave inner surface at such recessed portion of the core side moulding half. Due to such pressing action, the PV label is reliably fixed to the core side moulding half in a configuration in which it abuts to the inner surface and is therefore supported by the inner surface of the core side moulding half.

As a further feature, the moulding device comprises an injection arrangement. This injection arrangement is configured for injecting a viscous polymer mass into the cavity between the moulding halves. Specifically, the injection arrangement shall inject the polymer mass towards the rear surface of the PV label being arranged between the moulding halves. For such purpose, the injection arrangement may comprise one or more nozzles and/or ducts arranged at one or more injection locations along the inner surface of the cavity side moulding half. The nozzles and/or ducts may be supplied with the polymer mass using one or more pumps, conveyors or similar devices, wherein the polymer mass may be stored for example in a polymer reservoir. Optionally, the injection arrangement may include a heater arrangement for heating the polymer mass to an elevated temperature at and/or before its injection into the cavity.

Referring to the method according to the first aspect of the invention, in order to produce the PV panel with the moulding device, a support structure is prepared at a rear side of a PV label using an injection moulding procedure.

Therein, the PV label is first arranged between the two moulding halves and is pre-fixed such as to be located adjacent to the concave inner surface of the core side moulding half using the prefixing arrangement, while the moulding device being in its open state. In such prefixed configuration, the PV label may be planar or slightly curved with a curved portion of the PV label extending into the recessed portion of the curved inner surface of the core side moulding half. However, in such prefixed configuration, the PV label is not yet strongly pressed against such inner surface. Accordingly, in order to reliably hold and support the PV label during the subsequent polymer injection procedure, the pushing arrangement is used for pushing and thereby bending the PV label further into the recessed portion until the front surface of the PV label abuts to the concave inner surface at the recessed portion of the core side moulding half.

Subsequently, a volume of the viscous polymer mass is injected by the injection arrangement to the rear surface of the PV panel while the moulding device being successively closed or already being in its fully closed state. In other words, upon having the PV label stably fixed to the inner surface of the core side moulding half, the moulding halves are pushed towards each other thereby closing the moulding device and, during such closing action and/or upon having reached the fully closed state, polymer mass is injected into the cavity forming between the two moulding halves such as to cover at least portions of the rear surface of the PV label.

After having reached the fully closed state, the moulding device is kept in such state until the injected polymer mass is at least partly solidified. For example, such solidification may occur upon the polymer mass being a thermoplastic polymer and being cooled down below a plastification temperature. Alternatively the polymer mass may in principle also be a thermosetting polymer and the solidification may occur upon e.g. chemical reactions progressing throughout the polymer. After having reached a sufficient degree of solidification, the polymer mass forms the support structure for the PV label and the moulding device may be opened again by pulling the moulding halves away from each other. Finally, the PV label with the support structure attached thereto may be removed from the moulding device and may form the PV panel as the final fabrication product.

According to an embodiment of the proposed method, the polymer mass is injected at least partly before completely closing the moulding device to the closed state. Furthermore, upon closing the moulding device, the moving moulding half, in this embodiment, the core side moulding half, is pushed towards the fixed moulding half, in this embodiment, the cavity side moulding half so as to compress and thereby distribute the previously injected molten polymer mass along the rear surface of the photovoltaic label.

In other words, the moulding device and particularly its injection arrangement may be configured to start injecting the polymer mass already before the moulding halves have been fully displaced to the closed state. Particularly, before reaching the fully closed state, the injection arrangement may inject the polymer mass with a relatively low injection pressure. The injection pressure may be limited to an extent where forces applied to the PV label are small enough to reliably prevent any solar cell breakage. At such low injection pressures, the injected material, namely, the polymer mass initially injected into the cavity will generally not fill the entire cavity, i.e. will not flow along the entire rear side of the PV label and into each and every partial volume of the cavity, but, instead, will form a locally limited depot of polymer mass. Such polymer mass depot may then be distributed along the entire surface of the PV label upon the moulding halves being pushed towards each other when closing the moulding device, thereby successively reducing the volume of the cavity between the moulding halves. In other words, the compression injection moulding is a process that starts when the mould or moulding device is not completely closed. Due to this fact, the pressures inside the cavity are rather low compared to conventional injection moulding. This is especially beneficial for the solar cells comprised in the PV label with respect to breakage.

Finally, upon reaching the fully closed state, the entire cavity will be filled with the polymer mass and only when the injection phase is completed, then the injected mass will be compressed by the movement of the core side moulding half to the fully closed state, thereby filling then the complete mould cavity.

Finally, upon solidifying the polymer mass, the support structure may be produced.

Such procedure in which the polymer injection is already started when the moulding device is still in its at least slightly opened state and is then distributed upon further closing the moulding device by compressing and distributing it throughout the cavity may be referred to as injection compression moulding. Possible implementations of such injection compression moulding procedure are described in the other patent application filed by the applicant contemporarily with the present application, which shall be incorporated herein in its entirety by reference.

According to an embodiment of the proposed method, the photovoltaic label is pre-fixed to the core side moulding half by generating a local underpressure at a suction area using a suction arrangement being included in the pre-fixing arrangement, the suction area forming a partial area of the concave inner surface of the core side moulding half. Alternatively or additionally, the PV label may be pre-fixed by bringing pins provided in the interior of either one of the moulding halves into engagement with respective holes provided in the PV label, thereby, suspending it within the respective moulding half.

For such purpose, according to an embodiment of the proposed moulding device, the pre-fixing arrangement comprises a suction arrangement arranged at the inner surface of the core side moulding half. The suction arrangement is configured for generating an underpressure at a suction area forming a partial area of the inner surface of the core side moulding half.

Expressed differently, the pre-fixation of the PV label to the core side moulding half according to an embodiment may be established using a suction arrangement. Such suction arrangement may selectively and temporarily generate a local underpressure, i.e. a partial vacuum, at a suction area. The underpressure may be generated e.g. with a suction pump. The local underpressure may be strong enough to pull and keep the PV label fixed relative to the suction arrangement. For example, the PV label may be held in such fixed configuration by applying a pressure between 8 to 10 bars. The suction area is situated within the inner surface of the core side moulding half and forms a partial area thereof, such partial area having for example less than 5%, preferably less than 1% of the overall area of the inner surface.

Particularly, the suction area may be located at a portion of the inner surface of the core side moulding half which is covered by a portion of the PV label at which the solar cell arrangement is embedded in the PV label. In other words, the suction arrangement may be configured and arranged such that its suction area sucks the PV label at a location where solar cells are included in the PV label. Therein, the pre-fixation using the underpressure may be established in such preserving manner such as to avoid any excessive forces to be applied to the solar cell arrangement, thereby preventing any solar cell breakage.

Pre-fixing the PV label using a local underpressure may be established with relatively simple technical means. Furthermore, a fixation force applied to the PV label may be controlled by precisely controlling the underpressure generated by the suction arrangement. Additionally, such fixation force may be applied homogeneously along the suction area, thereby preventing local force peaks.

For example, according to an embodiment of the proposed moulding device, the suction arrangement comprises a suction cup having a rim which is displaceable between a relaxed configuration in which the rim protrudes beyond the inner surface of the core side moulding half and a pressed configuration in which the rim does not protrude beyond the inner surface of the core side moulding half.

In other words, the underpressure may be locally generated at the suction area using a specific suction cup. Such suction cup is specifically configured such that, when no underpressure is generated and the suction cup therefore being in a relaxed configuration, the rim of the suction cup extends beyond the inner surface of the core side moulding half. Accordingly, in such relaxed configuration, the PV label may easily reach the rim of the suction cup by being slightly pressed into the recessed portion at the inner surface of the core side moulding half. The PV label may then cover this rim tightly. Upon being covered in such manner, the underpressure may be generated within the suction cup. As a result of such applied underpressure, the suction cup may get into its pressed configuration in which, e.g. due to the underpressure, the rim no more protrudes beyond the inner surface of the core side moulding half but is e.g. substantially flush with such inner surface. Accordingly, the PV label being adhered to the suction cup due to the underpressure is pulled towards the inner surface such as to e.g. approach to or even slightly abut to the inner surface of the core side moulding half.

According to a further specified embodiment of the proposed moulding device, at least the rim of the suction cup, preferably the entire suction cup, consists of a flexible material.

For example, the suction cup or at least its rim may be made with an elastic and flexible material such as silicone, rubber, latex or similar substances. Accordingly, the suction cup and/or its rim may be provided with a geometry and deformability such that, upon being in the relaxed configuration, the rim protrudes into the recessed portion of the core side moulding half. Upon the underpressure being applied to an inner volume of the suction cup, the suction cup may then switch to its pressed configuration as the flexible rim or even the entire flexible suction cup deforms upon the action of the underpressure.

Such suction cup partly or entirely consisting of flexible material may be easily produced, may be robust and may be switched between its relaxed configuration and its pressed configuration multiple times without significant fatigue.

According to an embodiment of the proposed moulding device, the pre-fixing arrangement comprises plural suction arrangements arranged at various locations along the inner surface of the core side moulding half.

In other words, the PV label may not only be prefixed at the core side moulding half with a single suction arrangement but with several suction arrangements provided at different locations at the inner surface of the core side moulding half. Therein, each suction arrangement may generate an underpressure at a local suction area associated to this suction arrangement. For example, each suction arrangement may be implemented with at least one suction cup. The different suction arrangements may be located for example close to a periphery of the inner surface of the core side moulding half. Alternatively or additionally, at least one or more suction arrangements may be provided close to a centre of the inner surface of the core side moulding half. For example, the pre-fixing arrangement may comprise two, three, four or even more suction arrangements. Using such multiplicity of suction arrangements, the PV label may be reliably held and pre-fixed at the core side moulding half.

Upon having pre-fixed the PV label with the suction arrangement(s) in such manner, the PV label may then be further pushed with the displaceable plunger of the pushing arrangement until abutting with its front surface to the inner surface of the core side moulding half, thereby finally fixing the PV label in a stable and reliable manner in the recessed portion of the core side moulding half for subsequent polymer injection on its rear surface.

Therein, in accordance with an embodiment of the method proposed herein, the displaceable plunger is arranged and configured such that, upon pushing the photovoltaic label with the plunger, a pressing surface of the plunger comes into contact and then presses a partial area of the photovoltaic label towards the inner surface of the core side moulding half, wherein the pressing surface at least partially overlaps with the suction area.

According to an embodiment of the moulding device, the displaceable plunger comprises a pressing surface and the pushing arrangement is arranged and configured such as to displace the plunger with its pressing surface towards the suction area at the inner surface of the core side moulding half.

Expressed differently, the pushing arrangement may comprise one or more displaceable plungers. Particularly, in case that there are multiple suction arrangements comprised in the pre-fixing arrangement, the number of plungers in the pushing arrangement may correspond to the number of suction arrangements and one plunger may be associated to one of the suction arrangements, respectively. Therein, the plungers may be located and may be displaceable such that, upon displacing the respective plunger towards the inner surface of the core side moulding half, a pressing surface of this plunger is pushed towards the inner surface of the core side moulding half at a location where it overlaps with the suction area generated by the associated suction arrangement. Accordingly, the displaced plunger will contact a partial area of the PV label with its pressing surface and will push the PV label towards the inner surface of the core side moulding have while covering the partial area of the PV label. Upon subsequently injecting the viscous polymer to the rear side of the PV label, the polymer may distribute along the entire rear surface of the PV label except for the partial areas covered by the pressing surface(s) of the plunger(s).

Accordingly, in these partial areas, the injected polymer will not exert any substantial pressure onto the PV label during the polymer injection procedure. This may beneficially help preventing any local deformations of the PV label. Particularly, the plunger may be arranged with its pressing surface such that the partial area of the PV label being contacted by the pressing surface and therefore being protected against the pressure of the injected polymer at least partially overlaps with the suction area, or preferably fully covers the suction area, generated by the suction arrangement.

Without such protection of the plunger's pressing surface, the pressure generated upon polymer injection would act along the entire rear surface of the PV label and, particularly, would also act in the partial area where the PV label is not stably supported by abutting to the inner surface of the core side moulding half but where the PV label abuts to the suction arrangements of the prefixing arrangement. However, in such partial area abutting to the suction arrangement, e.g. a suction cup forming the suction arrangement may not stably support the PV label and, particularly, may not counteract any substantive injection forces. Accordingly, without being protected during the injection procedure, the PV label could suffer from local deformations upon being pressed towards and slightly into the flexible suction arrangement. Specifically configuring and arranging the plungers of the pushing arrangement such as to protect the PV label in the indicated partial areas may prevent such local deformations.

According to a further specified embodiment of the proposed method, a connection box may be electrically connected and mechanically attached to the photovoltaic label at the partial area being partially or fully covered by the pressing surface of the plunger during polymer injection.

In other words, the fact that the plunger covers the partial area of the PV label during the polymer injection procedure and thereby prevents any polymer mass from being deposited at this partial area may subsequently be used for getting access to the PV label at such exposed partial area. In fact, such local access is required in order to establish an electric contact to the solar cell arrangement embedded in the PV label. Such electric contact is typically made using a connection box via which the solar cell arrangement in the PV label may then be electrically connected to an external circuitry. Such connection box, which sometimes is also referred to as junction box, generally forms part of the final PV panel and may be attached to the PV label at the partial area where the polymer mass forming the support structure is locally open and exposes the underlying rear surface of the PV label. A cross section of the junction box may be similar or smaller than the exposed partial area of the PV label. The junction box may be electrically connected to electrical connectors comprised in the solar cell arrangement embedded in the PV label and may be mechanically attached to the PV label and/or to the support structure, e.g. by gluing, pressfitting, co-moulding and/or other techniques.

It shall be noted that possible features and advantages of embodiments of the invention are described herein partly with respect to a method of producing a PV panel and partly with respect to a moulding device for implementing such method. One skilled in the art will recognize that the features may be suitably transferred from one embodiment to another and features may be modified, adapted, combined and/or replaced, etc. in order to come to further embodiments of the invention.

### BRIEF DESCRIPTION OF THE DRAWINGS

In the following, advantageous embodiments of the invention will be described with reference to the enclosed drawings. However, neither the drawings nor the description shall be interpreted as limiting the invention.
Fig. 1 shows a top view of a PV panel in accordance with an embodiment of the present invention.
Fig. 2 shows a sectional view of the PV panel along the line A-A in Fig. 1.
Fig. 3 shows a sectional view of a PV label.
Fig. 4 shows a sectional view of a moulding device according to an embodiment of the present invention in a fully open state with the PV label being pre-fixed.
Fig. 5 shows a sectional view of a moulding device of Fig. 4 in a less open state with the PV label being pushed to the inner surface for the core side moulding half and with initial polymer injection.
Fig. 6 shows a sectional view of the moulding device of Fig. 4 in a closed state with complete polymer injection.
Fig. 7 shows a perspective view onto a core side moulding half of a moulding device according to an embodiment of the present invention.
Fig. 8, Fig. 8a show a pre-fixing arrangement according to another embodiment of the present invention.
Fig. 9 shows a perspective view of a suction cup of a suction arrangement for a pre-fixing arrangement in a moulding device according to an embodiment of the present invention.
Fig. 10 shows a sectional view of the suction cup of Fig. 8 with a PV label pre-fixed thereto in a relaxed configuration.
Fig. 11 shows a sectional view of the suction cup of Fig. 8 with a PV label pushed thereon in a pressed configuration.
Fig. 12 shows a partial sectional view of a PV panel produced according to an embodiment of the present invention with a connection box.

The figures are only schematic and not to scale. Same reference signs refer to same or similar features.

### DESCRIPTION OF PREFERRED EMBODIMENTS

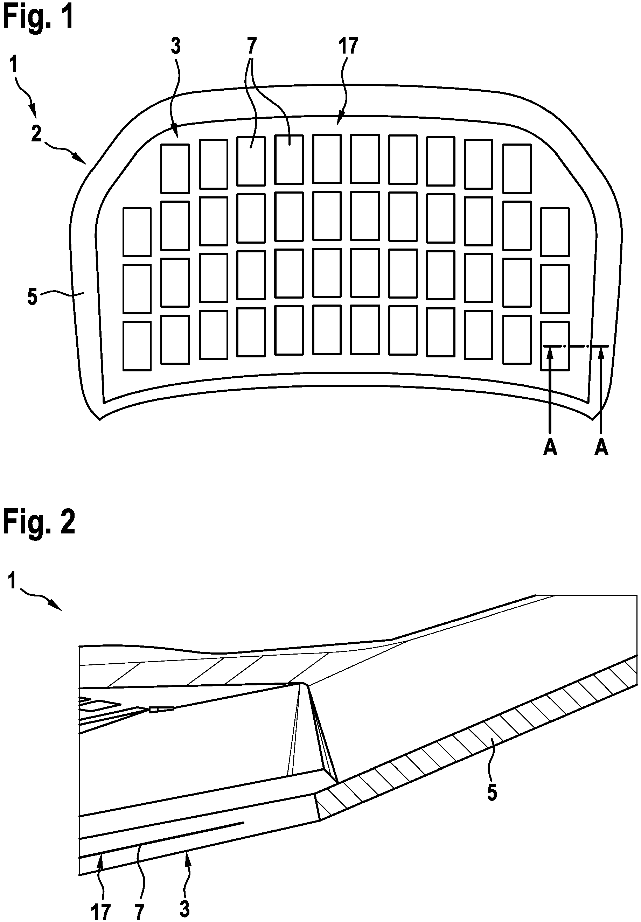

Fig. 1 shows a top view of a PV panel 1 which may be produced in accordance with the method described herein. Fig. 2 shows a sectional view along the line A-A indicated in Fig. 1.

The PV panel 1 comprises a sheet-like PV label 3 supported by a support structure 5. In this specific example, the PV panel 1 is embodied as a PV car body panel in the form of a car hood 2. The PV panel 1 forms a portion of a car body structure and comprises a curved geometry in accordance with a curved design of such a car body structure. The PV label 3 is incorporated into the PV panel 1 with its solar cells 7 being part of a solar cell arrangement 17 embedded in the PV label 3 and being arranged at an outer surface of the hood 2, such outer surface being at least slightly curved in two dimensions. The sheet-like PV label 3 has a thickness of about 2 mm to 4 mm and is supported at its rear side and at its circumference by the support structure 5 being made with a mouldable polymer material and having a thickness of typically about 1 mm to 5 mm. The thickness of the PV label 3 may slightly vary along its lateral extension, e.g. due to manufacturing tolerances, such variations typically being in a range of up to 20% relative to the mean thickness or up to 0.5 mm or even up to 1 mm absolute. The thickness of the support structure may vary along its lateral extension, e.g. due to different local mechanical requirements to be fulfilled by the support structure.

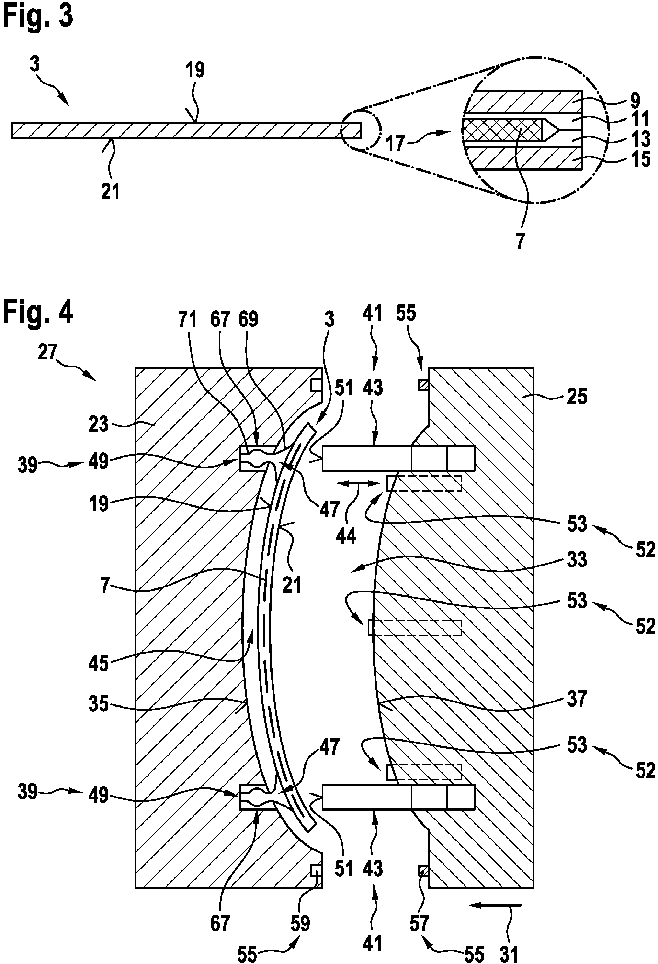

Fig. 3 shows a sectional view of an exemplary PV label 3 with a front surface 19 and a rear surface 21. The PV label 3 comprises a front side polymeric stabilisation foil 9, a front side polymeric lamination foil 11, a rear side polymeric lamination foil 13 and a rear side polymeric stabilisation foil 15. Furthermore, the solar cell arrangement 17 comprises multiple wafer-based solar cells 7 interposed between the front and rear side lamination foils 11, 13 of the PV label 3 and interconnected with each other. The various foils 9, 11, 13, 15 and the solar cell arrangement 17 are laminated such as to form an integral stack in which the fragile solar cells 7 are supported and protected e.g. against an impact of excessive external forces and/or bending forces.

Fig. 4, Fig. 5 and Fig. 6 show cross sectional views of a moulding device 27 in a fully open state, a less open state and a closed state, respectively. The moulding device 27 is specifically adapted for producing a PV panel 1 in accordance with the method described herein.

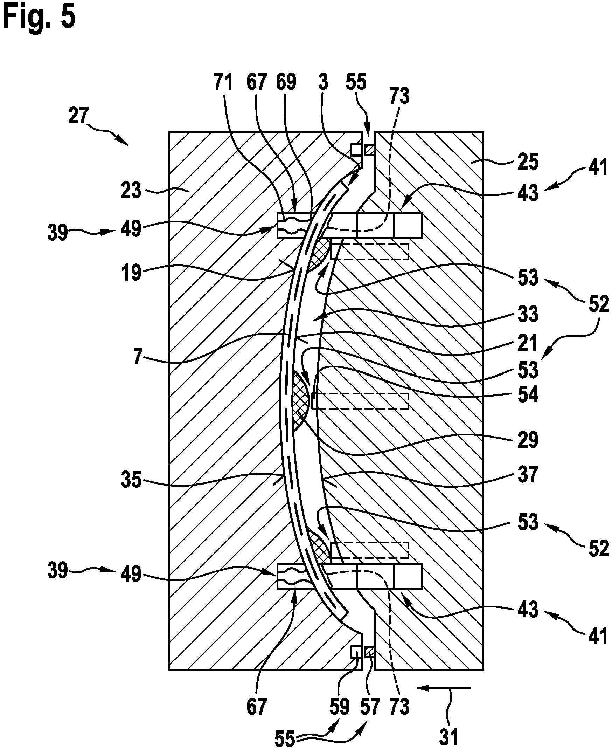

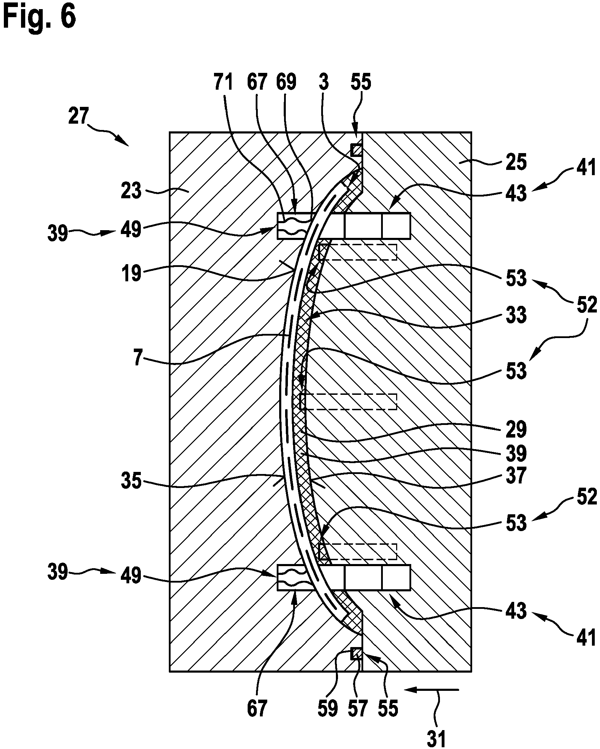

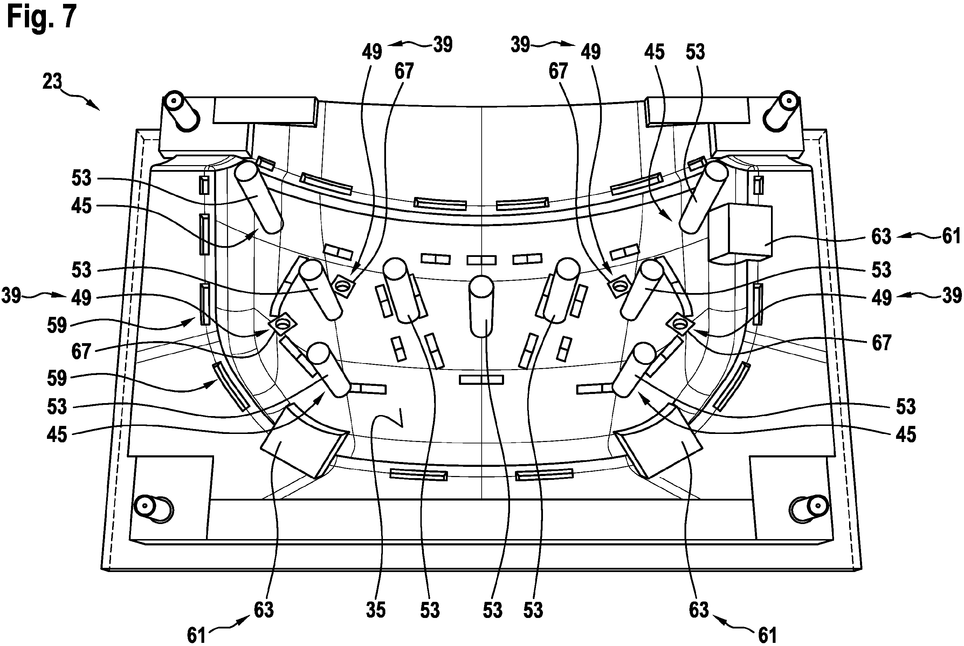

The moulding device 27 comprises a core side moulding half 23 and a cavity side moulding half 25. Fig. 7 shows a perspective view onto the core side moulding half 23. The two moulding halves 23, 25 are displaceable relative to each other in a displacement direction 31 from the fully open state shown in Fig. 4 via the less open state shown in Fig. 5 to the closed state shown in Fig. 6, or vice versa by moving the core side or moving moulding half 23 towards or away from the cavity side or fixed moulding half 24. If the configuration is vice versa, i. e., the moving moulding half is the cavity side moulding half 24 and the fixed moulding half is the core side moulding half 23, then the displacement direction 31 indicated in Fig. 4 will be opposite to the one shown here. The moulding halves 23, 25 comprise opposing inner surfaces 35, 37, wherein the inner surface 35 of the core side moulding half 23 is concave and thereby forms a recessed portion 45.

Therein, the inner surface 35 at the core side moulding half 23 and the inner surface 37 at the cavity side moulding half 25 are formed such that, even in the closed state of the moulding device 27, there remains enough volume in between both inner surfaces 35, 37 such as to form a cavity 33. A thickness of this cavity 33 is larger than a thickness of the PV panel 3. Accordingly, even when the moulding device 27 is fully closed or closed up to a predetermined closing point, and the PV panel 3 is comprised in the cavity 33, there remains an empty volume in the cavity 33. In this empty volume, a polymer mass 29 may be injected, as described in detail further below, such as to form the support structure 5 supporting the PV label 3.

According to an embodiment, the moulding device 27 further comprises a pre-fixing arrangement 39 and a pushing arrangement 41. The pre-fixing arrangement 39 is configured for temporarily fixing the PV label 3 at the core side moulding half 23 such that its front surface 19 is adjacent to the inner surface 35 of this core side moulding half 23 (see e.g. Fig. 4). The pushing arrangement 41 is configured such as to further push the PV label 3 towards the core side moulding half 23 such as to about to its concave inner surface 35 (see e.g. Fig. 5). Upon being fixed in such manner, the rear surface 21 of the PV label 3 is directed to the inner surface 37 of the cavity side moulding half 25 but is spaced from this inner surface 37 via the interposed remainder of the cavity 33.

In the example shown, according to this embodiment, the pre-fixing arrangement 39 comprises multiple suction arrangements 49 located at different positions along the concave inner surface 35 of the core side moulding half 23. Each suction arrangement 49 comprises the suction cup 67 and may generate an underpressure in a suction area 47 (see e.g. Fig. 4) so as to suck and pull the PV label 3 towards the inner surface 35 of the core side moulding half 23, thereby reliably pre-fixing the PV label 3. The suction cup 67 comprises the hollow cup body 71 and a flexible rim 69. The underpressure within the suction arrangement 49 may be generated e.g. using a pump (not shown) associated individually to each suction arrangement 49 or commonly connected to multiple suction arrangements 49. Possible details of the pre-fixing arrangement 39 are described further below.

The pushing arrangement 41 comprises a plunger 43 which may be displaced in a pushing direction 44 between a protruding configuration (as shown in Fig. 4) and a retracted configuration (as shown in Fig. 6) and vice versa. The pushing direction 44 may be parallel to the displacement directions 31 along which the two moulding halves 23, 25 may be displaced relative to each other. The pushing arrangement 41 may comprise an actuator (not shown) like an electromotor, a hydraulics, a pneumatics, etc. for actively displacing the plunger 43. Furthermore, the plunger 43 may be elastically biased in the pushing direction 44 using e.g. a spring (not shown). At a tip end face directed towards the inner surface 35 of the core side moulding half 23, the plunger 43 comprises a pressing surface 51. The pressing surface 51 has a contour which is substantially complementary to a partial area of the inner surface 35 of the core side moulding half opposite to the pressing surface 51. Further possible details of the pushing arrangement 41 are described further below.

Furthermore, the moulding device 27 comprises an injection arrangement 52. This injection arrangement 52 is configured for injecting the viscous polymer mass 29 into the cavity 33 towards the rear surface 21 of the PV label 3. In the example shown, the injection arrangement 52 comprises several nozzles 53 via which the polymer mass 29 may be injected and/or pressed into the cavity 33. The nozzles 53 are arranged at a plurality of injection locations throughout the cavity 33 (see also Fig. 7).

Finally, the moulding device 27 comprises an engagement arrangement 55 (only visualised in a very schematic manner) via which the displacement motion of the two moulding halves 23, 25 relative to each other may be precisely guided. In the example shown, this engagement arrangement 55 comprises protrusions 57 at the cavity side moulding half 25 close to a circumference around its inner surface 37 and complementary recessions 59 at the core side moulding half 23 close to its circumference around the inner surface 35.

Fig. 7 shows a perspective view onto the inner surface 35 of the core side moulding half 23. Four suction arrangements 49 of the pre-fixing arrangement 39 according to an embodiment are provided at different locations close to a periphery of the inner surface 35. Each suction arrangement 49 comprises one suction cup 67. Furthermore, in this visualisation, also the nozzles 53 of the injection arrangement 51 coming from the cavity side moulding half 25 are depicted. Therein, nine nozzles 53 are arranged at different injection locations. Finally, some brackets 63 of a positioning arrangement 61 are shown which may be used for pre-positioning the PV label 3 at the core side moulding half 23 in an intended position relative to the inner surface 35, before subsequently pre-fixing the PV label 3 using the pre-fixing arrangement 39.

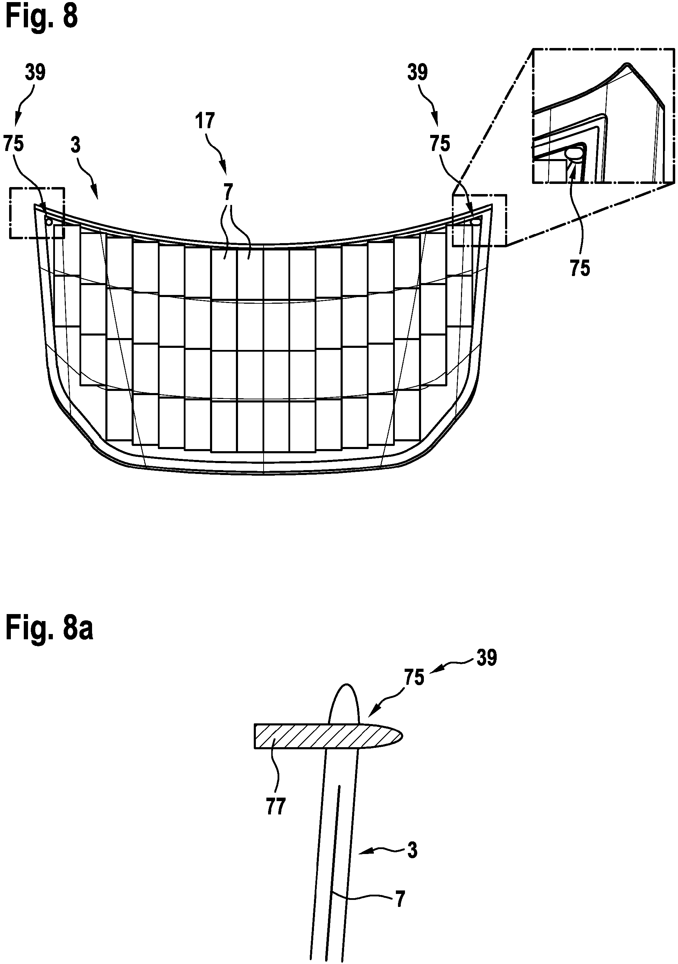

Fig. 8 and Fig. 8a show a further pre-fixing arrangement 39 according to another embodiment of the invention. Here, it can be seen that there are provided two through-holes 75 at the edges of the PVL 3. There may also be provided more than two pre-drilled or otherwise machined through-holes in the PVL 3 for providing further pre-fixation points. Respective pins 77 provided at the inner surface 35 of core side moulding half 23 (see Fig. 4), when pre-fixing the PVL 3, engage with the respective through-holes 75 such that the PVL according to this pre-fixation arrangement will be fixed in a hanging configuration within the core side moulding half 23.

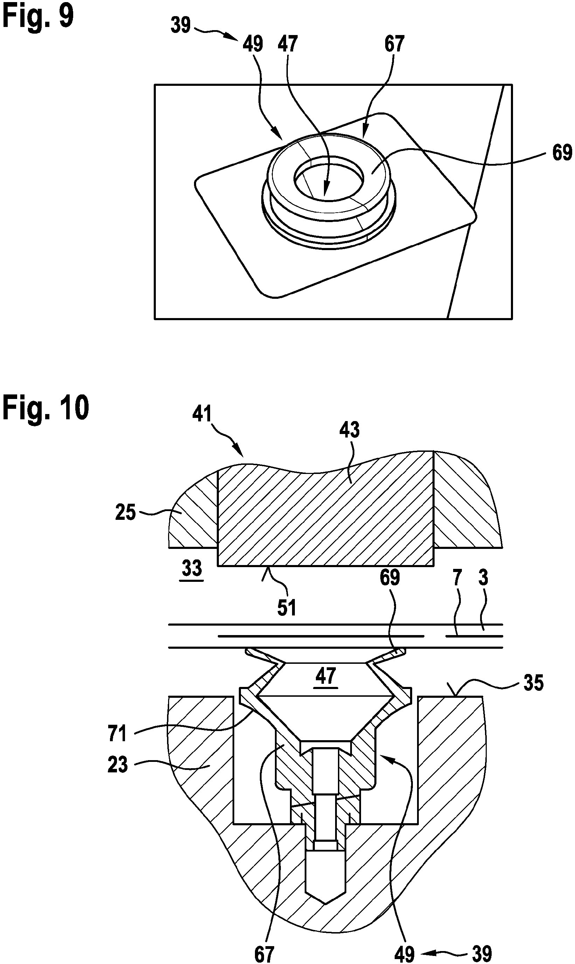

Fig. 9 shows a perspective view onto a suction cup 67 of one of the suction arrangements 49. Fig. 10 shows a sectional view of the suction cup 67 in a relaxed configuration. Fig. 10 shows a sectional view of the suction cup 67 in a pressed configuration.

Next, a sequence of steps of an embodiment of a method for producing a PV panel 1 is described with reference to the figures, particularly to figures 4 - 7, 10 and 11.

The PV label 3 may be produced in a preceding separate production procedure, in which the various stabilisation foils 9, 15 and lamination foils 11, 13 with the solar cell arrangement 17 being interposed are laminated to form a stack, which may then be handled as a unit.

The PV label 3 is then arranged between the two moulding halves 23, 25 upon the moulding device 27 being in its fully open state (see Fig. 4). Initially, the moulding halves 23, 25 may be arranged such as to be widely spaced from each other by several centimetres or decimetres, thereby enabling an easy access to the volume between both moulding halves 23, 25. Particularly, the PV label 3 may initially be handled manually or by a robot. First, the PV label 3 may be put into the brackets 63 of the positioning arrangement 61 for correctly positioning it with respect to the inner surface 35 of the core side moulding half 23.

Subsequently, the PV label 3 originally being in a substantially planar configuration may be slightly pressed towards the curved inner surface 35 of the core side moulding half 23. Specifically, the PV label 3 may be slightly pressed towards the suction cups 67 forming the suction arrangement 49. As the suction cups 67 are initially in their relaxed configuration and therefore the rim 69 of these suction cups 67 initially protrudes beyond the inner surface 35 of the core side moulding half 23 in a direction away from such inner surface 35 and towards the opposing cavity side moulding half 25 (see also Fig. 9), the PV label 3 may abut to and cover this rim 69. Accordingly, the rim 69 may act as a sealing lip between the cup body 71 of the suction cup 67 and the PV label 3 covering the rim 69. An underpressure may then be generated within the suction cup 67, thereby sucking and pre-fixing the PV label 3 by the suction arrangement 49. Accordingly, in such pre-fixed state, the PV label 3 no longer is required to be held manually or by a robot.

Subsequently, the moulding halves 23, 25 are displaced from their widely opened state towards a less widely opened state in which they are spaced from each other only by a few millimetres, for example between 5 and 6 mm. This state is represented in Fig. 5.

In such less opened state, the pushing arrangement 41 presses with its displaceable plungers 43 against the rear surface 21 of the PV label 3 and thereby pushes and bends the PV label 3 to a configuration in which it abuts with its front surface 19 to the recessed portion 45 of the concave inner surface 35 of the core side moulding half 23. Therein, the pressing surface 51 of the plunger 43 comes into contact and presses a partial area 73 of the PV label 3 towards the inner surface 35.

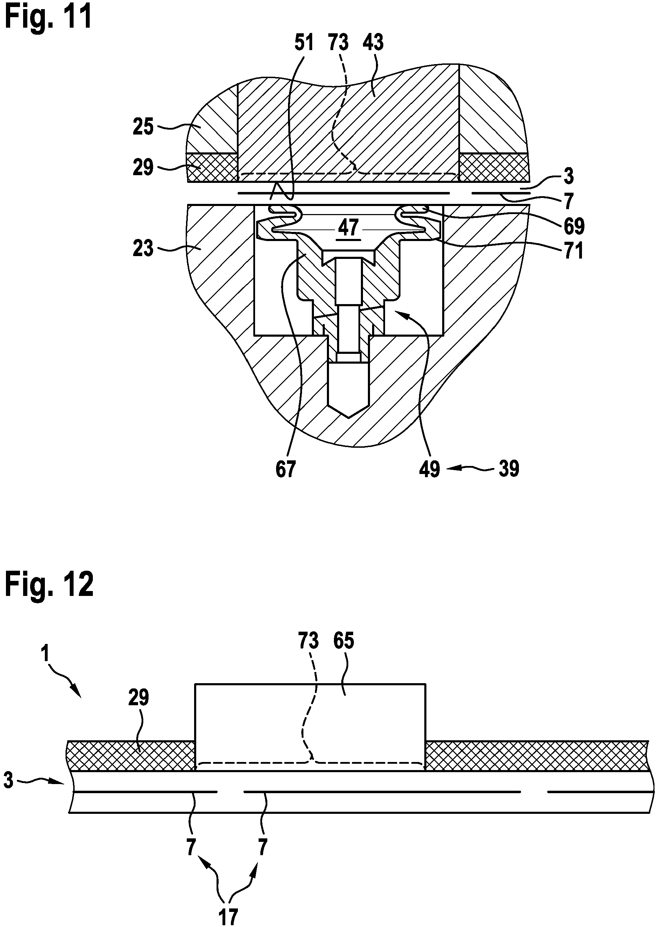

As also visualised in Fig. 11, the pressing surface 51 of the plunger 43 is dimensioned and located such that the partial area 73 of the PV label 3 pressed thereby fully covers the suction area 47 at which the suction arrangement 49 generates the underpressure.

Next, the injection procedure is initiated. Therein, viscous polymer mass 29 is injected into the cavity 33 via the nozzles 53 of the injection arrangement 52. Such injection procedure may include several substeps in which the rear surface 21 of the PV label 3 is successively covered with the viscous polymer mass 29, as visualized in Fig. 5 and Fig. 6 as well as Fig. 11. Possible details of such substeps are described in the applicant's further patent application filed contemporarily with the present application.

During the polymer injection, the PV label 3 is reliably held by the pushing arrangement 41. Furthermore, as the pressing surface 51 of the plunger 43 of this pushing arrangement 41 fully covers the suction area 47 of the suction arrangement 49, no excessive pressure exerted by the injected polymer is applied to the PV label 3 in the partial area 73 covering this suction area 47.

Accordingly, even though the suction cup 67 forming this suction area 47 is generally flexible and elastic and may therefore not counteract any substantial forces applied thereto, no deformations of the PV label 3 in the indicated partial area 73 are induced due to the partial area 73 being protected by the plunger 43 locally covering this area with its pressing surface 51.

Furthermore, as an additional effect, due to being covered by the plunger's 43 pressing surface 51, no polymer mass 29 is deposited on the indicated partial area 73 of the PV label 3. Accordingly, the partial area 73 of the PV label 3 remains exposed and may be used to obtain access to the solar cell arrangement 17. Accordingly, as visualised in Fig. 12, a connection box 65 may be attached to the PV panel 1 at this exposed partial area 73.

The polymer mass 29 being injected during the injection and compression procedure and finally forming a layer of polymer mass 29 may then solidify as a result of e.g. a cooling process and/or a chemical reaction process. After such solidification, the polymer mass 29 forms the support structure 5 for the PV panel 1. Accordingly, the moulding device 29 may be opened by pulling the moulding halves 23, 25 away from each other to bring the moulding device 27 in its fully opened state and the final PV panel 1 including the PV label 3 with the support structure 5 attached thereto may finally be removed from the moulding device 27.

Finally, it should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims.

### LIST OF REFERENCE SIGNS

- 1: PV panel
- 2: hood
- 3: PV label
- 5: support structure
- 7: solar cell
- 9: front side polymeric stabilisation foil
- 11: front side polymeric lamination foil
- 13: rear side polymeric lamination foil
- 15: rear side polymeric stabilisation foil
- 17: solar cell arrangement
- 19: front surface
- 21: rear surface
- 23: core side moulding half
- 25: cavity side moulding half
- 27: moulding device
- 29: polymer mass
- 31: displacement direction
- 33: cavity
- 35: inner surface of core side moulding half
- 37: inner surface of cavity side moulding half
- 39: pre-fixing arrangement
- 41: pushing arrangement
- 43: plunger
- 44: pushing direction
- 45: recessed portion
- 47: suction area
- 49: suction arrangement
- 51: pressing surface
- 52: injection arrangement
- 53: nozzle
- 55: engagement arrangement
- 57: protrusion
- 59: recession
- 61: positioning arrangement
- 63: bracket
- 65: connection box
- 67: suction cup
- 69: rim
- 71: cup body
- 73: partial area of PV label
- 75: through-hole
- 77: pin

## Claims

1. Method for producing a photovoltaic panel (1), the method comprising:
providing a sheet-like photovoltaic label (3) comprising front side and rear side polymeric foils (9, 11, 13, 15) as well as a solar cell arrangement (17) interposed between the front and rear side polymeric foils (9, 11, 13, 15), and
preparing a support structure (5) for supporting the photovoltaic label (3) using a moulding device (27) having two moulding halves (23, 25) including a core side moulding half (23) and a cavity side moulding half (25) being displaceable relative to each other between an open state and a closed state, wherein the core side moulding half (23) and the cavity side moulding half (25) are configured so as to, in the closed state of the moulding device (27), enclose a cavity (33), wherein the core side moulding half (23) comprises an inner surface (35) of a predetermined shape, and the moulding device further comprising a pre-fixing arrangement (39), a pushing arrangement (41) and an injection arrangement (52),
wherein the support structure (5) is prepared by
- pre-fixing the photovoltaic label (3) adjacent to the inner surface (35) of the core side moulding half (23) using the pre-fixing arrangement (39) as the moulding device (27) is in the open state,
- closing the moulding device (27) to the closed state by pushing the core side moulding half towards the cavity side moulding half and injecting a viscous polymer mass (29) to a rear surface (21) of the photovoltaic label (3) using the injection arrangement (52), and
- after solidification of the injected polymer mass (29) thereby forming the support structure (5), opening the moulding device (27) and removing the photovoltaic label (3) with the support structure (5) attached thereto from the moulding device (27).

2. Method according to claim 1,
wherein the polymer mass (29) is injected at least partly before completely closing the moulding device (27) to the closed state and wherein, upon closing the moulding device (27), the core side moulding half (23) is pushed towards the cavity side moulding half (25) so as to compress and thereby distribute the previously injected viscous polymer mass (29) across the rear surface (21) of the photovoltaic label (3).

3. Method according to one of the preceding claims,
wherein for pre-fixing the photovoltaic label (3), the method further comprises a step of pushing and thereby bending the photovoltaic label (3) using a displaceable plunger (43) of the pushing arrangement (41) such that the photovoltaic label (3) abuts with a front surface (19) to a recessed portion (45) of the inner surface (35) of the core side moulding half (23), and wherein the photovoltaic label (3) is pre-fixed to the core side moulding half (23) by generating a local underpressure at a suction area (47) using a suction arrangement (49) being included in the pre-fixing arrangement (39), the suction area (47) forming a partial area of the concave inner surface (35) of the core side moulding half (23), and/or by suspending the photovoltaic label (3) in the core side moulding half (23) by bringing respective through-holes (75) provided in the photovoltaic label (3) into engagement with respective pins (77) provided at the core side moulding half (23).

4. Method according to claim 3,
wherein the displaceable plunger (43) is arranged and configured such that, upon pushing the photovoltaic label (3) with the plunger (43), a pressing surface (51) of the plunger (43) comes into contact and then presses a partial area (73) of the photovoltaic label (3) towards the inner surface (35) of the core side moulding half (23), wherein the pressing surface (51) at least partially overlaps with the suction area (47).

5. Method according to claim 4,
wherein the pressing surface (51) fully covers the suction area (47).

6. Method according to one of claims 4 to 5,
further comprising:
electrically connecting and mechanically attaching a connection box (65) to the photovoltaic label (3) at the partial area (73) being partially or fully covered by the pressing surface (51) of the plunger (43) during polymer injection.

7. Method according to any one of the preceding claims wherein the photovoltaic panel (1) is a photovoltaic vehicle body panel or a photovoltaic panel for a building.

8. Moulding device (27) comprising:
- a core side moulding half (23) and a cavity side moulding half (25), wherein the core side moulding half is movable relative to the cavity side moulding half so as to open and close the moulding device, wherein the core side moulding half (23) and the cavity side moulding half (25) are configured so as to, in the closed state of the moulding device (27), enclose a cavity (33) and wherein the core side moulding half (23) comprises a planar or 3D-shaped inner surface (35),
- a pre-fixing arrangement (39) arranged at the core side moulding half (23) and configured for pre-fixing a sheet-like photovoltaic label (3) adjacent to the inner surface (35) of the core side moulding half (23),
- a pushing arrangement (41) configured for displacing a plunger (43) towards the inner surface (35) of the core side moulding half (23),
- an injection arrangement (52) configured for injecting a viscous polymer mass (29) towards the cavity (33).

9. Moulding device according to claim 8,
wherein the pre-fixing arrangement (39) comprises a suction arrangement (49) arranged at the inner surface (35) of the core side moulding half (23) and configured for generating an underpressure at a suction area (47) forming a partial area of the inner surface (35) of the core side moulding half (23).

10. Moulding device according to claim 9,
wherein the suction arrangement (49) comprises a suction cup (67) having a rim (69) which is displaceable between a relaxed configuration in which the rim (69) protrudes beyond the inner surface (35) of the core side moulding half (23) and a pressed configuration in which the rim (69) does not protrude beyond the inner surface (35) of the core side moulding half (23).

11. Moulding device according to claim 10,
wherein at least the rim (69) of the suction cup (67) consists of a flexible material.

12. Moulding device according to one of claims 9 to 11,
wherein the pre-fixing arrangement (39) comprises plural suction arrangements (49) arranged at various locations along the inner surface (35) of the core side moulding half (23).

13. Moulding device according to one of claims 9 to 12,
wherein the displaceable plunger (43) comprises a pressing surface (51) and the pushing arrangement (41) is arranged and is configured such as to displace the plunger (43) with its pressing surface (51) towards the suction area (47) at the inner surface (35) of the core side moulding half (23).

14. Moulding device according to one of claims 8 to 13 wherein the pre-fixing arrangement (39) comprises at least two pins (77) provided in the moulding device which are arranged so as to be able to engage with respective through-holes (75) provided in the photovoltaic label (3).
